# EUROPÄISCHE PATENTSCHRIFT

(11) **EP 2 721 558 B1**
(45) Veröffentlichungstag und Bekanntmachung des Hinweises auf die Patenterteilung: **13.04.2016**
(21) Anmeldenummer: 12729866.9
(22) Anmeldetag: 14.06.2012
(51) Int. Cl.: G06K 19/077

(54) **VERFAHREN ZUR HERSTELLUNG EINES DATENTRÄGERS MIT METALLFREIEM RAND**
METHOD FOR PRODUCING A DATA CARRIER HAVING A METAL-FREE EDGE
PROCÉDÉ POUR PRODUIRE UN SUPPORT DE DONNÉES PRÉSENTANT UN BORD EXEMPT DE MÉTAL

(30) Priorität: 17.06.2011 DE 102011104508
(43) Veröffentlichungstag der Anmeldung: 23.04.2014
(73) Patentinhaber: Giesecke & Devrient GmbH, 81677 München (DE)
(72) Erfinder: BÜTTNER, Bernhard, 82110 Germering (DE); TARANTINO, Thomas, 83410 Laufen (DE); GRIESMEIER, Robert, 83052 Bruckmühl OT Heufeldmühle (DE)
(86) Internationale Anmeldenummer: PCT/EP2012/002529
(87) Internationale Veröffentlichungsnummer: WO 2012/171648

(56) Entgegenhaltungen:
- DE-A1- 10 145 752
- DE-A1-102004 028 218
- DE-C1- 19 703 058

## Beschreibung

Die Erfindung betrifft ein Verfahren zur Herstellung eines tragbaren Datenträgers, insbesondere einer Chipkarte sowie einen tragbaren Datenträger, ein Trägerband und die Verwendung des Datenträgers als Teilnehmeridentifikationsmodul, kurz (U)SIM. Besonders betrifft die Erfindung die Herstellung von Chipkarten mit kleineren Außenabmessungen, als die zum Zeitpunkt der Anmeldung normierten Standardabmessungen liegen.

Im ISO/IEC 7816-2 Standard sind die Abmessungen für den kleinsten Formfaktor, der sogenannte 3FF oder "Micro-SIM" oder "Mini-Plug-In" definiert. Dieser 3FF Standard hat die Außenmaße von ca.12 mm x 15 mm. In der ISO/IEC 7816-2 Norm sind darüber hinaus auch die Mindestgröße, die Anzahl und die genaue Lage der Kontaktflächen des Kontaktfeldes von Chipkarten beschrieben. Die Fläche für ein standardisiertes Kontaktfeld mit sechs Kontaktflächen beträgt 9,62 Millimeter mal 6,78 Millimeter. Die Fläche für eine Kontaktfläche beträgt 1,7mm mal 2mm.

Gemäß der DE 10 2004 028 218 A1 ist ein Herstellungsverfahren für Datenträger bekannt, bei dem ein Trägerband, auch als Filmträger bezeichnet, vorgesehen ist. Auf einer Oberseite des Trägerbandes wird ein Kontaktfeld mit einzelnen Kontaktflächen ausgebildet. Anschließend wird ein Halbleiterschaltkreis auf eine der Oberseite gegenüberliegenden Unterseite angeordnet und elektrisch mit den Kontaktflächen der Oberseite verbunden. Abschließend wird der Halbleiterschaltkreis auf der Unterseite mittels einer Vergussmasse ummantelt. Dies geschieht bevorzugt in einem Spritzgussprozess. Die Vergussmasse weist dabei bereits die Außenmaße, der in der Normungsspezifikation für die Außenmaße eines tragbaren Datenträgers entsprechend beschriebenen Außenmaße auf. Auf die gesamte Offenbarung der DE 10 2004 028 218 A1 wird hier ausdrücklich Bezug genommen.

Der tragbare Datenträger steht dabei mit dem Endgerät über die physikalische Schnittstelle eines Kontaktfelds zum Austausch von Daten in Kommunikationsverbindung. Es ist allgemeiner Trend, dass diese Endgeräte stetig kleiner, kompakter und mit mehr Funktionalität ausgestattet werden. Durch die zunehmende Miniaturisierung von mobilen Kommunikationsendgeräten und der stets steigenden Funktionsfähigkeit dieser Geräte, ist es wünschenswert, auch die im Endgerät betriebenen tragbaren Datenträger zu verkleinern. Mit weiterer Miniaturisierung der Endgeräte wird diese benötigte Fläche jedoch nicht geringer, sodass die Gesamtgröße der Endgeräte durch die standardisierten Größen der Datenträger stark beeinflusst wird.

In Anbetracht einer zunehmenden Miniaturisierung von mobilen Kommunikationsendgeräten bzw. einer steigenden Funktionalität der Kommunikationsendgeräte, ist ein stetiges Bedürfnis an der weiteren Verkleinerung der als "Mini-Plug-In" bezeichneten Standard für SIM-Chipkarten abzusehen und wünschenswert.

Ein Bedürfnis ist weiterhin, dass die Datenträger weiterhin in älteren Kommunikationsgeräten bzw. in Endgeräten, die einen anderen Formfaktor für SIM-Karten benötigen, betrieben werden können, somit ist es wünschenswert das standardisierte Kontaktfeld auch für zukünftige Formstandards beizuhalten. Die kleinste denkbare Fläche, die ein Datenträger zukünftig aufweisen sollte, ist die Fläche des Kontaktfelds.

Mit einem Herstellungsverfahren gemäß der DE 10 2004 028 218 A1 ist es möglich Kartenkörper zu formen, die die Fläche des Kontaktfeldes nicht überschreiten oder bei denen der Rand des Kontaktfeldes eine geringe Distanz zu dem Randbereich des Datenträgerkörpers aufweist.

Heutige Kontaktflächen sind mehrschichtig ausgebildet. Zunächst wird eine Kupferschicht als Basisschicht gebildet. Auf dieser Kupferschicht wird eine Nickelschicht ausgebildet. Abschließend wird auf der Nickelschicht eine Goldschicht ausgebildet.

Das Ausbilden dieser Kontaktflächen erfolgt heutzutage in einem elektrochemischen Prozess, insbesondere der Galvanotechnik. Unter Galvanotechnik versteht man die elektrochemische Abscheidung von metallischen Niederschlägen auf Gegenständen. Bei der Galvanik wird durch ein elektrolytisches Bad Strom geschickt. An der Anode befindet sich das Metall, das aufgebracht werden soll, z. B. Kupfer, an der Kathode der zu beschichtende Gegenstand. Der elektrische Strom löst dabei Metall-Ionen von der Verbrauchselektrode ab und lagert sie durch Reduktion auf der Ware ab. So wird der zu veredelnde Gegenstand allseitig gleichmäßig mit Kupfer oder einem anderen Metall beschichtet. Je länger sich der Gegenstand im Bad befindet und je höher der elektrische Strom ist, desto stärker wird die entsprechende Metallschicht. Dazu werden elektrische Zuleitungen benötigt, um die einzelnen Kontaktflächen auf dem Trägerband ausbilden zu können. Der Aufbau der Zuleitungen ist daher identisch mit dem Aufbau der Kontaktflächen. Diese Zuleitungen sind auch nach der Herstellung des Datenträgers elektrisch leitend mit dem Datenträger verbunden.

Mit diesem Verfahren zum Ausbilden der Kontaktflächen mittels elektrochemischer Prozesse würden die Zuleitungen somit in den Randbereich des Datenträgers führen.

Wird der Datenträger nun bestimmungsgemäß zum Datenaustausch in ein Endgerät eingebracht, wird er zumeist mechanisch lösbar im Endgerät fixiert, beispielsweise durch Einklemmen, Einrasten oder Einschieben bzw. allgemein durch Halten des Datenträgers. Aufgrund der Beschaffenheit der metallischen Halterung im Endgerät kann es zu elektrischen Kurzschlüssen oder zumindest elektrischen Kontaktierungen der Randbereiche der Kontaktflächen bzw. der Zuleitungen mit der Halterung im Endgerät kommen, wenn die Kontaktflächen bis an den Rand ausgebildet sind oder die Zuleitungen auch im Randbereich des Datenträgers angeordnet sind. Dies ist insbesondere bei metallischen Halterungen problematisch.

DE 101 45 752 A offenbart ein nicht leitendes Band oder einen Nutzen bildendes Substrat, auf dem eine Vielzahl an Trägerelementen, insbesondere zum Einbau in eine Chipkarte, ausgebildet ist, die jeweils durch eine Begrenzungslinie gebildet sind, welches Substrat eine mit einer Kontaktseitenmetallisierung versehene Kontaktseite und eine der Kontaktseite gegenüberliegende Einsatzseite aufweist, wobei die Einsatzseite mit einer leitenden Einsatzseitenmetallisierung versehen ist, wobei die Kontaktseitenmetallisierung Bereiche innerhalb jeder Begrenzungslinie aufweist, die ein erhöhtes Widerstandsmoment im Bereich der integrierten Schaltung bewirken und die Einsatzseitenmetallisierung derart ausgebildet ist, dass eine elektrische Verbindung zwischen Kontaktstellen einer später auf der Einsatzseite aufzubringenden integrierten Schaltung und der Einsatzseitenmetalliserung mittels Flip- Chip-Kontaktierung erfolgen kann.

DE 197 03 058 C offenbart ebenfalls ein nicht leitendes Band oder einen Nutzen bildendes Substrat, auf dem eine Vielzahl von Trägerelementen, insbesondere zum Einbau in eine Chipkarte, ausgebildet ist, indem die eine Seite des Substrats mit leitenden Kontaktflächen versehen ist, die innerhalb einer die Größe eines Trägerelementes bestimmenden Außenkonturlinie liegen, wobei die andere Seite des Substrats mit Leiterstrukturen versehen ist, die innerhalb der Außenkonturlinie zumindest Kontaktfelder für wenigstens eine zu kontaktierende Spule und wenigstens einen Halbleiterchip bilden und wobei außerhalb jeder Außenkonturlinie Ausnehmungen im Substrat sind, durch die hindurch zu Testzwecken ein Zugriff auf Spulenanschlüsse des Halbleiterchips von der Kontaktflächenseite möglich ist, solange das Trägerelement noch im Band oder im Nutzen ist.

Der Erfindung liegt daher die Aufgabe zugrunde, einen Datenträger herzustellen, der zuverlässig im Endgerät funktioniert und kostengünstig produziert werden kann. Insbesondere sollen die bisher verwendeten elektrochemischen Prozesse für das Ausbilden der Kontaktflächen weiterhin angewendet werden. Insbesondere soll der Datenträger keine Fehlfunktionen aufgrund von Zuleitungen zu den Kontaktflächen beim Betreiben des Datenträgers aufweisen. Insbesondere weist der Datenträger im Vergleich zum Zeitpunkt der Anmeldung standardisierten Außenmaße verkleinerte Abmessungen auf.

Die Aufgabe der Erfindung wird durch die in den nebengeordneten unabhängigen Patentansprüchen beschriebenen Maßnahmen gelöst. Vorteilhafte Ausgestaltungen sind in den jeweils abhängigen Ansprüchen beschrieben.

Die Aufgabe wird durch ein Verfahren zur Herstellung eines tragbaren Datenträgers, insbesondere einer Chipkarte, mit den folgenden Verfahrensschritten gelöst. Bereitstellen eines Trägerbands mit einer Oberseite und einer der Oberseite gegenüberliegenden Unterseite; und Ausbilden eines Kontaktfeldes mit mindestens einer Kontaktfläche in einem elektrochemischen Prozess auf einer Oberseite des Trägerbands. Die für das Ausbilden der einen Kontaktfläche benötigte elektrische Zuleitung im Randbereich der Kontaktfläche wird anschließend entfernt und/ oder diese Zuleitung wird am Rand der Kontaktfläche mit einer elektrisch isolierenden Beschichtung ausgebildet. Wurden Kontaktflächen auch in den Randbereich des Datenträgers ausgebildete, so werden diese Randbereiche der Kontaktfläche ebenfalls entfernt und/ oder elektrisch isolierend beschichtet. Die Fläche für eine gemäß ISO/IEC 7816 Norm standardisierte Kontaktfläche sollte dabei nicht unterschritten werden.

Insbesondere sollten die Datenträger einen umlaufenden metallfreien Rand aufweisen, sodass der Datenträger beim Einbringen in eine metallische Halterung eines Endgeräts keine elektrischen Kurzschlüsse erzeugt. Beispielsweise beträgt der metallfreie Rand mindestens 1mm.

Dadurch werden die bei den Standardherstellungsprozessen zwangsläufig auftretenden Zuleitungen und über die Mindestgröße der Kontaktfläche nicht mehr das elektrische Potential der entsprechenden Kontaktflächen aufweisen. Somit sind die Endgerätehersteller frei in der Ausgestaltung der Halterungen für die Datenträger und eine Fehlfunktion des Datenträgers während des bestimmungsgemäßen Betriebs ist vermieden.

Im Folgenden wird unter dem Begriff Zuleitungen alles zusammengefasst, was über die gemäß ISO/IEC 7816 standardisierte Mindestgröße für eine Kontaktfläche hinausgeht und auch über die gemäß ISO/IEC 7816 standardisierte Mindestgröße für ein Kontaktfeld mit sechs Kontaktflächen hinaus auf dem Trägerband ausgebildet ist. Derzeit umfasst die standardisierte Mindestgröße für eine Kontaktfläche 1,7mm mal 2,2mm. Derzeit umfasst die standardisierte Mindestgröße für ein Kontaktfeld mit sechs Kontaktfläche 9,62mm mal 6,78mm.

Insbesondere wird für das Herstellungsverfahren eines Halbleiterschaltkreises auf der Unterseite des Trägerbands angeordnet, anschließend wird der Halbleiterschaltkreis mit den entsprechenden Kontaktflächen elektrisch leitend verbunden. Anschließend wird ein Spritzgussprozesses ausgeführt, wobei auf der Unterseite um den Halbleiterschaltkreis herum eine Vergussmasse ausgebildet wird und diese Vergussmasse die Außenmaße gemäß einer derzeitigen und/ oder zukünftigen Standardspezifikation eines tragbaren Datenträgers aufweist. Damit können die Datenträger weiter verkleinert werden. Da durch diese Herstellung der Bereich zwischen Kontaktfeld und Außenkontur des Datenträgers verkleinert, im Idealfall sogar null wird, ist die Gefahr, dass die herstellungsbedingten Zuleitungen in den Randbereich des Datenträgers ragen immens höher und ein Entfernen oder elektrisches isolieren der Zuleitungen notwendig. Auch werden gegebenenfalls die Kontaktflächen größer ausgebildet als im Standard gefordert, sodass diese in den Randbereich der Außenkontur des Datenträgers ragen können.

Alternativ kann ein selektives Ätzverfahren angewendet werden, indem der Bereich der Zuleitungen während des Ausbildens der Kontaktflächen bereits maskiert wird. Insbesondere wird das Kontaktfeld auf der Oberseite aus mehreren Schichten aufgebaut ist. Nach dem Ausbilden einer ersten Schicht, insbesondere einer Kupferschicht, werden die Zuleitung maskiert werden, sodass oberhalb der Zuleitung keine weiteren Schicht, insbesondere keine Nickel- oder Goldschicht, mehr ausgebildet werden. Das spätere Wegätzen der Kupferschicht allein ist technisch einfacher und unter Einsatz weniger aggressiver Chemikalien möglich. Dem Fachmann sind derartige Ätzmethoden und chemische Substanzen aus dem Stand der Technik bekannt.

Es erfolgt das Entfernen der Zuleitung mittels hochenergetischer Strahlung, insbesondere Laserstrahlung. Vorteilhaft ist hierbei, dass die hochenergetische Strahlung sehr genau punktuell platziert werden kann und der Laser vergleichsweise schnell mechanisch präzise ausgerichtet werden kann, sodass das Entfernen der Zuleitungen sehr genau und sehr schnell erfolgen kann.

In einer bevorzugten Ausgestaltung wird die Zuleitung mittels eines Schneidwerkzeugs durchtrennt und/ oder abgetragen, wobei das Trägerband dabei nicht durchtrennt wird. Da das Trägerband sehr robust ist, kann das Schneidwerkzeug die Zuleitung sehr gründlich entfernen.

In einer alternativen Ausgestaltung wird die Zuleitung passiviert und/ oder lackiert. Somit ist beim Einsetzen in eine mechanische Halterung die Gefahr von Kurzschlüssen und anschließenden Fehlfunktionen des Datenträgers stark verringert.

Es versteht sich von selbst, dass für jede auszubildende Kontaktfläche eine Zuleitung vorhanden sein muss. Daher muss das Verfahren gegebenenfalls auf mehrere Zuleitungen angewendet werden.

In einer bevorzugten Ausgestaltung verlaufen die Zuleitungen für die einzelnen Kontaktflächen innerhalb des Kontaktfeldes. Insbesondere werden alle Zuleitungen gebündelt, sodass das Verfahren nur an einer Stelle auf der Oberseite des Datenträgers angewendet werden muss. Daher wird die Herstellung des Datenträgers gegebenenfalls beschleunigt.

Bevorzugt wird der Datenträger während der Herstellung in einer Personalisierungseinheit zugeführt, wo der Halbleiterschaltkreis entsprechend elektrisch personalisiert wird, wodurch eine Individualisierung des Datenträgers erfolgt.

Bevorzugt wird der Datenträger während der Herstellung optisch personalisiert und erst nach der optischen Personalisierung vereinzelt.

Bevorzugt werden auf dem Trägerband eine Vielzahl von Datenträger hergestellt und erst nach der Fertigstellung insbesondere nach der elektrischen Personalisierung, vereinzelt. Dies geschieht, indem der mit der Vergussmasse verbundene Teil des Trägerbandes von dem restlichen Trägerband getrennt wird.

Im Erfindungsgedanken ist ebenfalls ein tragbarer Datenträger, insbesondere eine Chipkarte, zum kontaktbehafteten Datenaustausch mit einem Endgerät enthalten. Dazu weist der Datenträger ein Trägerband mit einer Oberseite und einer der Oberseite gegenüberliegenden Unterseite; ein Kontaktfeld auf der Oberseite mit mindestens einer Kontaktfläche und einer für das Ausbilden der Kontaktfläche benötigten elektrischen Zuleitung; ein Halbleiterschaltkreis auf der Unterseite, elektrisch verbunden mit der zumindest einen Kontaktfläche; einen Datenträgerkörper aus einem Vergussmassematerial auf. Die Vergussmasse umgibt den Halbleiterschaltkreis. Die Vergussmasse weist die Außenmaße gemäß einer Standardspezifikation eines tragbaren Datenträgers auf. Im Randbereich der Kontaktfläche ist die Zuleitung entfernt und/ oder die Zuleitung ist im Randbereich elektrisch isolierend beschichtet.

Im Erfindungsgrundgedanken ist ebenfalls ein Trägerband für die Herstellung eines tragbaren Datenträgers. Dieses Trägerband weist eine Oberseite und eine der Oberseite gegenüberliegende Unterseite; zumindest eine Kontaktfläche auf der Oberseite, wobei die Kontaktfläche eine Zuleitung auf. Die Zuleitung ist für das Ausbilden der Kontaktfläche notwendig. Die Zuleitung ist im Randbereich der Kontaktfläche entfernt und/ oder die Zuleitung weist im Randbereich der Kontaktfläche eine elektrisch isolierende Schicht auf.

Der Datenträger wird bevorzugt als Teilnehmeridentifikationsmodul für den bestimmungsgemäßen Einsatz in einem Endgerät verwendet. Dazu weist das Teilnehmeridentifikationsmodul die Funktionalitäten auf, wie sie in der technischen Spezifikationen ETSI TS 102 221 und ETSI TS 102 671, als sogenannten Universal Integrated Circuit Cards, kurz UICC, beschrieben sind.

Die Außenkontur des Teilnehmeridentifikationsmoduls ist mit Ausnahme der Oberseite metallfrei ist.

Bei dem erfindungsgemäßen tragbaren Datenträger handelt es sich vorzugsweise um Datenträger mit entsprechenden Sicherheitsfunktionalitäten, wie z.B. Smartcards, Chipkarten, Token und/ oder Teilnehmeridentifikationskarten in einem mobilen Funknetz, um durch eine entsprechende Authentisierung einen Zugang zu gesicherten Bereichen oder Dienstleistungen zu erhalten, z. B. die über ein Mobilfunknetzes bereitgestellten Applikationen eines Mobilfunkanbieters. Es ist auch möglich dass das Teilnehmeridentifikationsmodul als M2M Modul als fester Bestandteil im Datenträger eingebracht wird.

Nachfolgend wird anhand von Figuren die Erfindung bzw. weitere Ausführungsformen und Vorteile der Erfindung näher erläutert, wobei die Figuren lediglich Ausführungsbeispiele der Erfindung beschreiben. Gleiche Bestandteile in den Figuren werden mit gleichen Bezugszeichen versehen. Die Figuren sind nicht als maßstabsgetreu anzusehen, es können einzelne Elemente der Figuren übertrieben groß bzw. übertrieben vereinfacht dargestellt sein.

Es zeigen:
Figur 1 Ein Trägerbandausschnitt mit ausgebildeten Kontaktfeldern und Zuleitungen gemäß dem Stand der Technik
Figur 2 Einen Datenträger mit einem Kontaktfeld mit sechs Kontaktflächen und entsprechenden Zuleitungen gemäß dem Stand der Technik
Figur 3 Ein erfindungsgemäßes Kontaktfeld mit sechs Kontaktflächen und gebündelten Zuleitungen
Figur 4 Ein erfindungsgemäßer Trägerbandausschnitt mit Stanzungen der Randbereiche der Kontaktflächen
Figur 5 Ein Querschnitt an der Schnittlinie A-A' des in Figur 4 dargestellten Trägerbands
Figur 6 Ein Querschnitt an der Schnittlinie A-A' des in Figur 4 dargestellten Trägerbands mit ummantelnder Vergussmasse
Figur 7 Ein Querschnitt an der Schnittlinie A-A' zur Darstellung eines alternativen erfindungsgemäßen Herstellungsverfahrens
Figur 8 Ein Folgeschritt des in Figur 7 dargestellten erfindungsgemäßen Herstellungsverfahrens
Figur 9 Ein erfindungsgemäßes Maskieren der Zuleitungen beim Ausbilden der Kontaktflächen

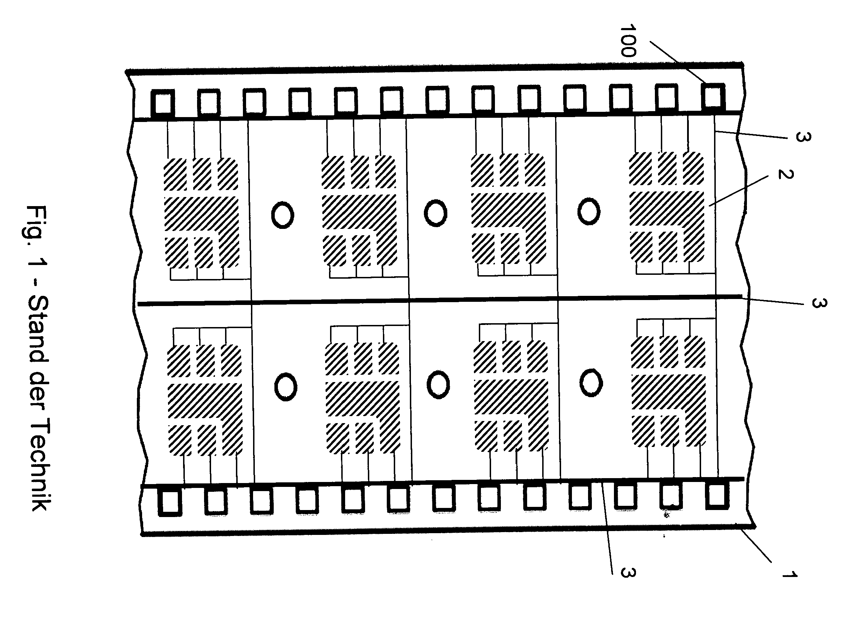

In Figur 1 ist ein Ausschnitt eines Trägerbands 1 in einer Draufsicht aus dem Stand der Technik dargestellt. Das Band 1 stellt das Ausgangsmaterial für das erfindungsgemäße Herstellungsverfahren dar. Das Trägerband 1 ist beispielsweise ein Filmträger aus einem rollbaren Trägermaterial auf Kunststoffbasis und/ oder sogenanntes FR-4, also ein glasfasergestärktes Epoxid-Laminat, der an den Seiten Perforationen 100 zur Unterstützung des Transports bei der Verarbeitung aufweist.

Zur Ausbildung der Kontaktflächen wird ein elektrochemisches Verfahren angewendet. Dazu ist es notwendig, dass der Bereich, an dem die jeweilige Kontaktfläche C1 bis C7 ausgebildet werden soll, mit einer elektrischen Zuleitung 3 kontaktiert wird. Diese Zuleitungen 3 werden dann ebenso ausgebildet, wie die eigentlichen Kontaktflächen C1 bis C7 des Kontaktfelds 2.

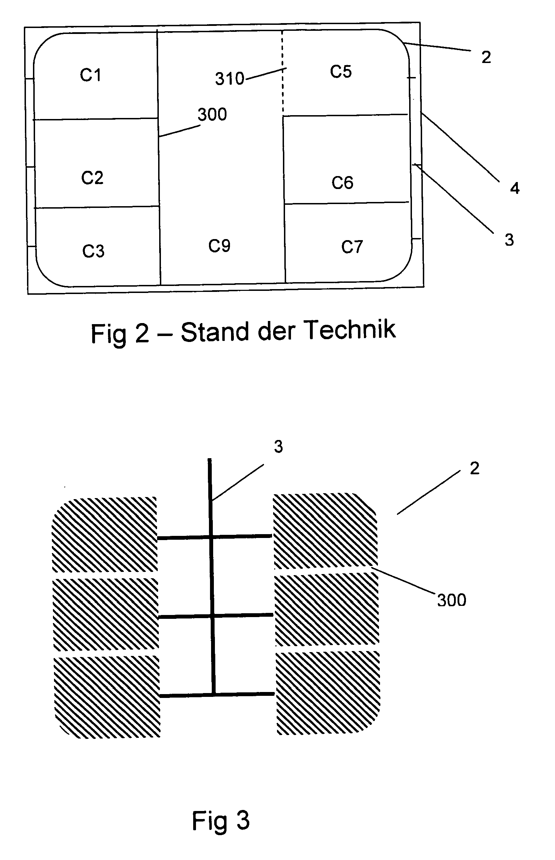

Die Kontaktfelder 2 entsprechen dabei einem Normlayout für Chipkarten gemäß ISO/IEC 7816. In Figur 2 ist ein vereinzelter Datenträger mit einem Datenträgerkörper 4 und einem ausgebildeten Kontaktfeld 2 mit sechs beziehungsweise sieben Kontaktflächen dargestellt, der eine wesentlich kleinere Oberfläche als die gemäß 3FF Standard bislang spezifizierte Ausführungsform eines Datenträgers aufweist. Die Kontaktflächen C1, C2, C3, C5, C6 und C7 sind untereinander elektrisch getrennt, was durch die Trennlinie 300 angezeigt wird. Ein derart miniaturisierter Datenträger gemäß Figur 2 ist beispielsweise in der DE 10 2011100 070 vom Anmelder am 29. April 2011 beim DPMA eingereicht oder in der DE 10 2011101 297 vom Anmelder am 11. Mai 2011 beim DPMA eingereicht, beschrieben. Darin ist auch die Ausgestaltung des Kontaktfelds 2 mit einer siebten Kontaktflächen C9 beschrieben, die eine zusätzliche Trennlinie 310 benötigt. Die Kontaktfläche C9 ist insbesondere nützlich, wenn man mit einer Vielzahl unterschiedlicher Kommunikationsprotokolle, beispielsweise USB, ISO, SWP Daten mit einem Endgerät austauschen möchte. Die Belegung der Kontakte und die Beschaltung kann den erwähnten Anmeldungen ebenfalls entnommen werden.

In Figur 2 ist ersichtlich, dass die für das Ausbilden der Kontaktflächen C1 bis C9 notwendige Zuleitung 3 sehr stark in den Randbereich des Datenträgers angeordnet sind, was zu dem eingangs erläuterten Problem beim Einsetzen und Betreiben des Datenträgers in ein Endgerät auftritt. Auch die Kontaktflächen C1 bis C9 selbst sind größer als die in der ISO/IEC7816-2 Norm geforderte Mindestgröße für Kontaktflächen von 1,7mm mal 2mm beziehungsweise die in der ISO/IEC7816-2 Norm geforderte Mindestgröße für ein Kontaktfeld mit sechs Kontaktflächen von 9,62 Millimeter mal 6,78 Millimeter. Somit kann es vorkommen, dass nach Ausbilden des Datenträgerkörpers 4 der Randbereich des Datenträgers Metall aufweist, der mit einer Kontaktfläche C1 bis C9 verbunden ist und in einer metallischen Halterung im Endgerät Fehlfunktionen hervorruft.

Gemäß Figur 3 ist ein erstes Ausführungsbeispiel der Erfindung dargestellt. Bei der Verwendung eines sechs Kontaktflächen Kontaktfelds 2 ist es möglich die Mitte des Kontaktfelds zum Verlegen der Zuleitungen 3 zu verwenden. Dadurch werden die äußeren Ränder der Kontaktflächen frei von Zuleitungen 3 und eine elektrische Fehlfunktion während des Betriebs im Endgerät wäre verhindert. Durch Bündeln der Zuleitungen, wie in Figur 3 dargestellt, wird weiterhin gewährleistet, dass für das Ausbilden der Kontaktfeldes 2 alle Kontaktflächen C1 bis C7 elektrisch kontaktierbar sind und der elektrochemische Prozess angewendet werden kann. Um die einzelnen Kontaktflächen untereinander elektrisch zu isolieren, sind Trennlinien 300 im Layout vorgesehen. Die gebündelten Zuleitungen 3 werden nur zu einer Seite aus dem Kontaktfeld 2 herausgeführt. Diese eine Seite des Kontaktfeldes ist bevorzugt eine Seite des Datenträgerkörpers bei dem der Abstand zwischen Kontaktfeld und Datenträgeraußenkontur maximal ist im Vergleich zu anderen Seiten des Kontaktfelds.

Durch das hier vorgeschlagene Konzentrieren der Anbindungen an die Kontaktflächen auf eine Stelle müssen keine Folgeschritte der Herstellung angepasst werden, wodurch das bestehende Problem ohne zusätzlichen Prozessschritt gelöst wird.

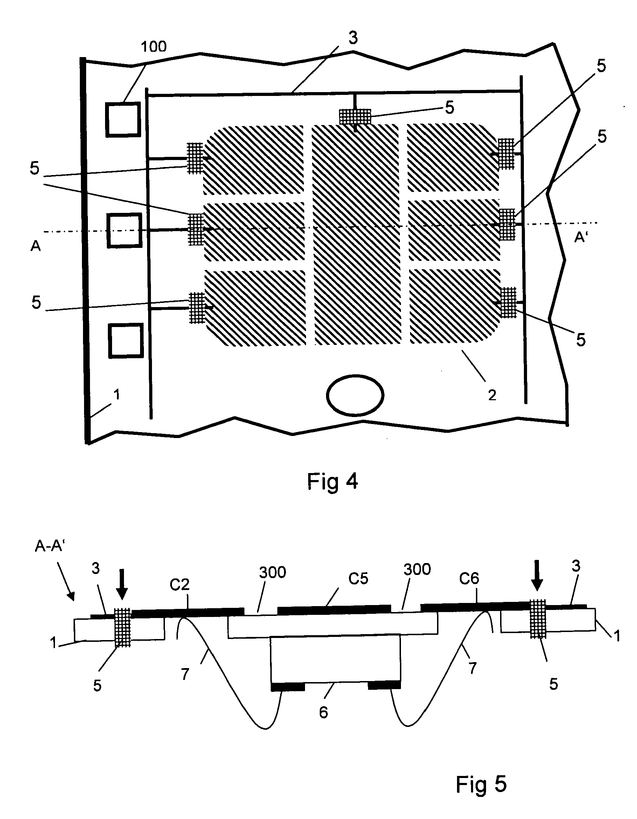

In den Figuren 4, 5, 6 ist ein zu Figur 3 alternatives Verfahren gezeigt. Das Trägerband 1 besitzt eine Dicke d. Das Material für das Trägerband 1 ist so gewählt, dass es einerseits eine gute Verbindung mit einer aufspritzbaren Vergussmasse eingeht und andererseits die Qualitäten einer Deckschicht eines fertigen tragbaren Datenträgers besitzt. Alternativ wird das Material der Vergussmasse derart gewählt, dass es eine gute Verbindung zum Trägerband 1 eingeht. An der Oberseite des Trägerbands 1 sind, wie in Fig.1 gezeigt, Kontaktfelder 2 mit einer Mehrzahl von einzelnen Kontaktflächen C1 bis C9 ausgebildet. Der dargestellte Ausschnitt aus einem Trägerband 1 zeigt genau ein Kontaktfeld 2 mit sieben Kontaktflächen C1 bis C9. Die Zuleitungen 3 zu den einzelnen Kontaktflächen dienen der elektrischen Kontaktierung während des elektrochemischen Prozesses zum Ausbilden der Kontaktflächen C1 bis C9. Die Bezeichnungen für C4 und C8 als mögliche USB Kontaktflächen sind speziell für zukünftige Standards nicht vorgesehen, sodass eine mögliche Ausgestaltung des Kontaktfeldes 2 für USB Protokoll über eine weitere Kontaktfläche C9 realisiert werden könnte.

An der Unterseite des Trägerbands 1 sind zu den Kontaktflächen C1-C9 des Kontaktfelds 2 korrespondierende Kontaktierung zum Anschluss eines Halbleiterschaltkreises 6 ausgebildet, die mit den Kontaktflächen C1 - C9 über geeignete Durchkontaktierung verbunden sind. Bei Verarbeitung von der Rolle befindet sich auf einem Trägerband 1 eine Vielzahl von Kontaktfeldern 2, die in einem Abstand p angeordnet sind. Das erfindungsgemäße Verfahren ist aber gleichermaßen durchführbar mit einem Trägerband 1, auf dem jeweils genau ein Kontaktlayout 28 ausgebildet ist. Das erfindungsgemäße Verfahren ist gleichermaßen durchführbar bei einer Herstellung von Datenträgern bei denen der Träger kein Band sondern in Form eines Bogens ausgestaltet ist.

An der Unterseite des Trägerbands 1 ist, wie in Figur 5 dargestellt, jeweils ein Halbleiterschaltkreis 6 angeordnet und elektrisch mit den Kontaktierungsflächen C1-C9 verbunden. Diese elektrischen Kontaktierungen 7 zwischen Kontaktflächen C1-C9 und dem Halbleiterschaltkreis 6 sind beispielsweise als Wirebond oder FlipChip Verdrahtungen ausgestaltet.

Bei dem Halbleiterschaltkreis 6 handelt es sich um einen für Chipkarten typischen "Chip", d.h. um einen durch Prozessierung eines Wafers erzeugten integrierten Schaltkreis, der in der Regel alle Merkmale eines ressourcenbeschränkten Computers aufweist. Herstellung des Chips ebenso wie die Vorbereitung des Trägerbands 1 durch Aufbringen von Kontaktlayout, Kontaktierungsflächen und Chip sind in der Fachwelt bekannt und unter anderem in dem Buch "Vom Plastik zur Chipkarte" oder auch in dem Buch "Hand-buch der Chipkarten" von W. Rankl, W. Effing, Hanser Verlag, 4. Auflage, ausführlich beschrieben. Für Details zur Durchführung der Bearbeitungsschritte wie zu Aufbau und Funktion des integrierten Schaltkreises wird deshalb auf die einschlägige Literatur, insbesondere die genannten Bücher, verwiesen.

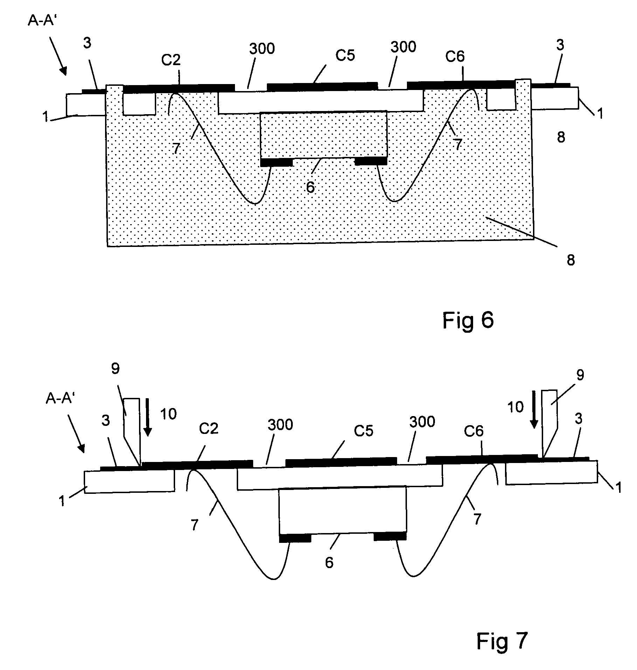

Gemäß Figur 4 und 5 sind in den Randbereichen der einzelnen Kontaktflächen zusätzliche Stanzungen 5 gezeigt. Diese Stanzungen werden idealerweise während der Herstellung in das Trägerband 1 mit einem geeigneten Stanzwerkzeug eingebracht und Durchtrennen die Zuleitungen 3 im Randbereich der Kontaktflächen C1-C9 beziehungsweise verkleinern die Kontaktflächen C1-C9, ohne dabei die Mindestfläche von 1,7mm mal 2mm zu unterschreiten. Alternativ erfolgt die Stanzung und das Durchtrennen der Zuleitungen vor bzw. während der Modulherstellung erfolgen. Dadurch sind die Zuleitungen an diesen Stellen entfernt, wie insbesondere in der Querschnittsdarstellung entlang der Schnittlinie A-A' in Figur 5 zu sehen ist. Im Spritzgießschritt wird gemäß Fig. 6 der Halbleiterchip ummantelt, wobei die Vergussmasse 8 bereits die Außenmaße des Datenträgers aufweist. Durch die Stanzungen 5 wird die Vergussmasse auch in die entsprechenden Löcher der Stanzungen 5 fließen, wodurch die Stabilität des Datenträgers erhöht und insbesondere die Delamination des Trägerbands 1verhindert wird.

Das für den Spritzgießvorgang zu verwendende Werkzeug besteht aus zwei Gießformhälften, wobei die untere Gießformhälfte an der Oberseite des Trägerbands 1 anliegt und als Unterlage dient. Die obere Gießformhälfte liegt dicht auf der Unterseite des Trägerbands 1 auf und umschließt unter Belassen einer Kavität den Halbleiterschaltkreis 6 mit Kontaktierungsflächen C1-C9 und ggf. vorhandenen weiteren Kontaktierungsstrukturen, etwa in Form von Bonddrähten. Die von der oberen Gießformhälfte umschlossene Kavität besitzt die für den fertigen tragbaren Datenträger angestrebte äußere Endform, ggf. korrigiert um einen Höhenabzug für die Dicke d des Trägerbands 1. Bei der Endform des Datenträgerkörpers 4 kann es sich insbesondere um eine Geometrie mit den Standardabmessungen handeln, wie sie ggf. zukünftig von ETSI als neues Format diskutiert wird.

Der so bereits weitgehend fertig gestellte tragbare Datenträger wird anschließend individualisiert. Hierzu wird der Chipkartenkörper 4 mit darin eingebettetem Halbleiterschaltkreis 6 an eine Test- und Personalisierungseinrichtung gebracht. Diese verfügt insbesondere über eine Lese/ Schreibeinrichtung mit Kontaktstiften, welche auf die Kontaktflächen C1 bis C9 stoßen, um eine Datenverbindung zu dem Halbleiterschaltkreis 6 herzustellen. Über diese Datenverbindung wird der Halbleiterschaltkreis 6 sodann in üblicher Weise getestet und anschließend mit individualisierenden Daten versehen, indem z.B. eine Seriennummer eingeschrieben wird.

Der getestete und individualisierte tragbare Datenträger wird nachfolgend einer Beschriftungsstation zugeführt, wo er z.B. mittels eines Lasers oder durch Bedrucken mit einem Inkjet-Drucker beschriftet oder mit grafischen Elementen versehen wird. Die Schritte der datenmäßigen Individualisierung und der nachfolgenden Beschriftung erfolgen zweckmäßig in der Rolle, d.h. während die Vergussmasse 8 noch mit dem Trägerband 1 verbunden ist. Die Perforationen 100 ermöglichen dabei eine einfache Bewegung des Trägerbands 1.

Der individualisierte Datenträger wird sodann vereinzelt. Mittels eines geeigneten Werkzeuges, z.B. einem Stanzwerkzeug, werden dabei die außerhalb der Vergussmasse 8 liegenden Teile des Trägerbands 1 entfernt. Der mit der Vergussmasse 8 verbundene Teil des Trägerbands 1verbleibt auf dem Vergussmasse 8 und wird zur Deckschicht des fertigen tragbaren Datenträgers. Alternativ zum Stanzen kann das Entfernen des Trägerbands 1 auch durch Schneiden, durch Einsatz eines Lasers oder durch ein chemisches Vereinzeln erfolgen. Der Vereinzelungsschritt kann auch zu einem früheren Zeitpunkt erfolgen, d.h. vor dem Beschriften oder vor dem Individualisieren in der Personalisierungseinrichtung. Die Durchführung der weiteren Bearbeitungsschritte kann dann z.B. im "Tray", d.h. in einer Art Tablett mit Vertiefungen, worin einzeln die Datenträger liegen, durchgeführt werden.

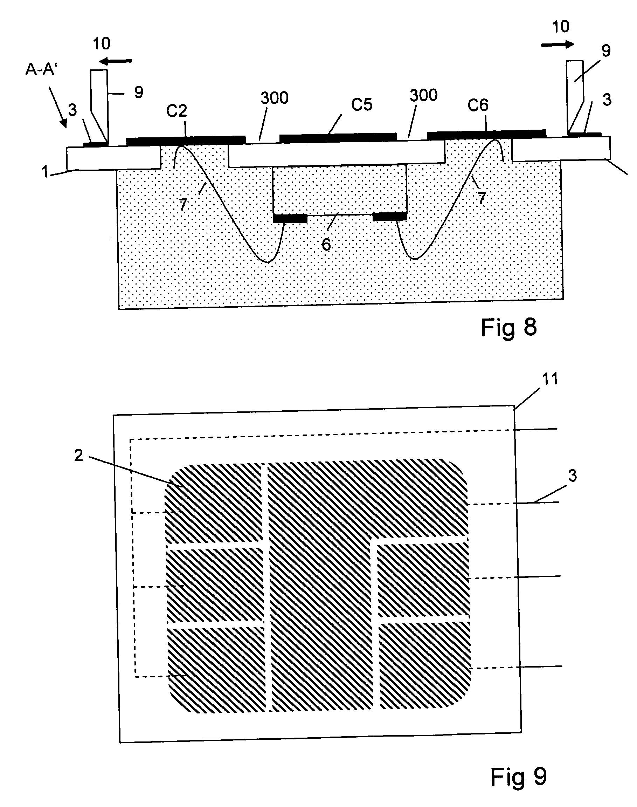

In Figur 7 ist ein zu den Figuren 4 bis 6 alternatives Herstellungsverfahren dargestellt. Hier wird das Kontaktfeld 2 mit den Flächen C1 bis C9 wie gehabt mit Hilfe der Zuleitungen 3 ausgebildet. Anstelle eines Stanzvorgangs gemäß Figuren 4 bis 6 wird nun ein Schneidwerkzeug 9 in zwei unterschiedlichen Bewegungsrichtungen eingesetzt. Zunächst wird das Schneidwerkzeug 9 zum Durchtrennen der Zuleitungen 3 und der überschüssigen Kontaktflächenbereiche C1 bis C9 in einer ersten Bewegungsrichtung 10 angewendet, wie in Figur 7 dargestellt. Dazu wird das Schneidwerkzeug bis auf das Trägerband 1 geführt. In einem Folgeschritt, dargestellt in Figur 8, wird das Schneidwerkzeug 9 eine zur ersten Bewegungsrichtung orthogonalen zweiten Bewegungsrichtung 10 geführt, wodurch das Schneidwerkzeug 9 entlang des Trägerbands 1 jeweils von der jeweiligen Kontaktfläche C1 bis C9 weggeführt wird. Durch diese zweite Bewegungsrichtung 10 wird die Zuleitung 3 und ggf. die zu groß geratene Kontaktfläche C1 bis C9 entfernt. Anstelle des Schneidwerkzeugs 9 kann die zu entfernende Teil der Kontaktfläche auch mittels Druckluft, mittels eines Haftklebers oder durch eine Mechanische Reinigungsvorrichtung, insbesondere eine Bürste, entferntn werden.

Anstelle eines Schneidwerkzeugs besteht auch die Möglichkeit mittels hochenergetischer Strahlung, beispielsweise generiert durch eine Laserquelle, die Zuleitungen 3 teilweise und/ oder komplett zu entfernen.

In Figur 9 ist ein weiteres alternatives Ausführungsbeispiel der Erfindung dargestellt. Standardmäßig werden Kontaktflächen und auch Leiterbahnen auf einer Chipkarte aus drei Schichten aufgebaut, einer Basisschicht aus Kupfer, einer darüberliegenden Nickelschicht und einer abschließenden Goldschicht. Die Reihenfolge und Anzahl der Schichten ist hier nur beispielhaft erwähnt. Beim Verfahren gemäß Figur 9 wird zunächst das Kontaktflächenlayout verwendet, um diese mehrschichtigen Kontaktflächen auszubilden. Für das Ausbilden einer ersten Kupferschicht in Galvanotechnik wird dabei wie gewohnt im vorgegangen, sodass sowohl Kontaktflächen als auch Zuleitungen im elektrochemischen Prozess gebildet werden. Im Folgeschritt wird eine Maskierung 11 verwendet, um die Zuleitungen und Randbereich der Kontaktflächen C1 bis C9 abzudecken. Diese Maske deckt also alle Bereiche ab, die nicht mit den Folgeschichten aus Nickel und Gold bedeckt werden sollen. Dadurch sind die Zuleitungen nicht mit Gold und Nickel beschichtet, sondern bestehen nur aus Kupfer. Diese Kupferschicht lässt sich vergleichsweise leicht in einem Ätzprozess entfernen, sodass nur die mehrschichtigen Kontaktflächen übrig bleiben. Geeignete Materialien zum Wegätzen von Kupfer sind dem Fachmann bekannt.

Nicht figürlich dargestellt, aber trotzdem als Ausführungsform denkbar sind selektive Ätzverfahren, bei denen mittels selektiver Belichtung ausgewählt wird, welcher Teil weggeätzt werden soll.

Alternativ und ebenfalls figürlich nicht dargestellt, ist das Lackieren oder Passivieren der Zuleitungen, um diese gegenüber dem Endgerät elektrisch zu isolieren.

### Bezugszeichenliste

1 Trägerband
   - 100: Perforation
2 Kontaktfeld mit Kontaktflächen
   - C1: Spannungsversorgung
   - C2: Reset
   - C3: Takt
   - C5: Masse
   - C6: SWP
   - C7: I/O für ISO Protokoll
   - C9: Zusätzliche Kontaktfläche
3 Zuleitungen für Kontaktflächen
   - 300: Trennlinie zwischen Kontaktflächen
   - 310: Zusätzliche Trennlinie (optional)
4 Chipkartenkörper
5 Stanzung
6 Halbleiterschaltkreis
7 Elektrische Kontaktierung zwischen Halbleiterschaltkreis und Kontaktflächen
8 Vergussmasse
9 Schneidwerkzeug
10 Bewegungsrichtung des Schneidwerkzeugs
11 Maskierung

## Patentansprüche

1. Verfahren zur Herstellung eines tragbaren Datenträgers, insbesondere einer Chipkarte, mit den Verfahrensschritten:
- Bereitstellen eines Trägerbands (1) mit einer Oberseite und einer der Oberseite gegenüberliegenden Unterseite; und
- Ausbilden eines Kontaktfeldes (2) mit mindestens einer Kontaktfläche (C1-C9) in einem elektrochemischen Prozess auf einer Oberseite des Trägerbands (1) wobei
- die für das Ausbilden der einen Kontaktfläche (C1-C9) benötigte elektrische Zuleitung (3) im Randbereich der Kontaktfläche (C1-C9) entfernt wird und diese Zuleitung (3) am Rand der Kontaktfläche (C1-C9) mit einer elektrisch isolierenden Beschichtung ausgebildet wird,
**dadurch gekennzeichnet, dass** das Entfernen der Zuleitung (3) und/oder der Kontaktflächen (C1-C9) im Randbereich mittels hochenergetischer Strahlung erfolgt.

2. Verfahren gemäß Anspruch 1, wobei das Verfahren weiter umfasst:
- Anordnen eines Halbleiterschaltkreises (6) auf der Unterseite des Trägerbands (1);
- Elektrisches Verbinden der Kontaktfläche (C1-C9) mit dem Halbleiterschaltkreis (6); und
- Ausführen eines Spritzgussprozesses in der Art, dass auf der Unterseite um den Halbleiterschaltkreis (6) herum eine Vergussmasse (8) ausgebildet wird, wobei diese Vergussmasse (8) die Außenmaße gemäß einer Standardspezifikation eines tragbaren Datenträgers aufweist.

3. Verfahren gemäß einem der vorhergehenden Ansprüche wobei die Zuleitung (3) und/ oder die Kontaktflächen (C1-C9) im Randbereich mittels eines Schneidwerkzeugs (9) durchtrennt und/oder abgetragen werden.

4. Verfahren gemäß einem der vorhergehenden Ansprüche, wobei die Zuleitung (3) und/oder die Kontaktflächen (C1-C9) im Randbereich passiviert und/oder lackiert werden.

5. Verfahren gemäß einem der vorhergehenden Ansprüche, wobei die Zuleitung für die einzelnen Kontaktflächen (C1-C9) innerhalb des Kontaktfeldes (2) verläuft.

6. Verfahren nach einem der vorhergehenden Ansprüche, wobei das Kontaktfeld (2) aus mehreren Schichten ausgebildet wird und nach dem Ausbilden einer ersten Schicht, insbesondere einer Kupferschicht, die Zuleitung (3) und die zu entfernenden Bereiche der Kontaktflächen (C1-C9) maskiert werden, sodass oberhalb der maskierten Bereiche keine weitere Schicht, insbesondere keine Nickel- oder Goldschicht, ausgebildet werden.

7. Verfahren nach einem der vorhergehenden Ansprüche, wobei der Datenträger vor einem Vereinzelungsschritt in einer Personalisierungseinheit elektrisch und/oder optisch personalisiert wird, wodurch eine Individualisierung des Datenträgers erfolgt.

8. Verfahren nach einem der vorhergehenden Ansprüche, wobei der Datenträger vereinzelt wird, indem der mit der Vergussmasse verbundene Teil des Trägerbandes von dem restlichen Trägerband getrennt wird.

## Claims

1. A method for manufacturing a portable data carrier, in particular a chip card, with the method steps of:
- making available a carrier band (1) with an upper side and a lower side disposed opposite the upper side; and
- forming a contact field (2) with at least one contact area (C1-C9) in an electrochemical process on an upper side of the carrier band (1), wherein
- the electrical feed line (3) required for forming the one contact area (C1-C9) is removed in the edge region of the contact area (C1-C9) and said feed line (3) at the edge of the contact area (C1-C9) is formed with an electrically insulating coating,
**characterized in that** the removal of the feed line (3) and/or of the contact areas (C1-C9) in the edge region is effected by means of high-energy radiation.

2. The method according to claim 1, wherein the method further comprises:
- arranging a semiconductor circuit (6) on the lower side of the carrier band (1);
- electrically connecting the contact area (C1-C9) with the semiconductor circuit (6); and
- executing an injection molding process in such a fashion that on the lower side a potting compound (8) is formed around the semiconductor circuit (6), wherein said potting compound (8) has the outer dimensions according to a standard specification of a portable data carrier.

3. The method according to any of the preceding claims, wherein the feed line (3) and/or the contact areas (C1-C9) in the edge region are severed and/or stripped by means of a cutting tool (9).

4. The method according to any of the preceding claims, wherein the feed line (3) and/or the contact areas (C1-C9) in the edge region are passivated and/or lacquered.

5. The method according to any of the preceding claims, wherein the feed line for the individual contact areas (C1-C9) extends within the contact field (2).

6. The method according to any of the preceding claims, wherein the contact field (2) is formed of several layers and after forming a first layer, in particular a copper layer, the feed line (3) and the regions of the contact areas (C1-C9) to be removed are masked, such that above the masked regions no further layer, in particular no nickel or gold layer, are formed.

7. The method according to any of the preceding claims, wherein the data carrier is electrically and/or optically personalized in a personalization unit before a singling step, thereby individualizing the data carrier.

8. The method according to any of the preceding claims, wherein the data carrier is singled by separating the portion of the carrier band that is connected with the potting compound from the rest of the carrier band.

## Revendications

1. Procédé de fabrication d'un support de données portable, en particulier d'une carte à puce, comprenant les étapes de procédé:
- mise à disposition d'une bande support (1) ayant une face de dessus et une face de dessous opposée à la face de dessus; et
- engendrement d'un champ de contact (2) ayant au moins une surface de contact (C1-C9) dans un processus électrochimique sur la face de dessus de la bande support (1), cependant que
- la conduite électrique d'amenée (3) nécessaire à l'engendrement de la une surface de contact (C1-C9) est enlevée dans la zone marginale de la surface de contact (C1-C9), et cette conduite d'amenée (3) est établie en marge de la surface de contact (C1-C9) avec un revêtement électriquement isolant,
**caractérise en ce que** l'enlèvement de la conduite d'amenée (3) et/ou des surfaces de contact (C1-C9) a lieu dans la zone marginale au moyen de rayonnement haute énergie.

2. Procédé selon la revendication 1, le procédé comprenant en outre:
- agencement d'un circuit à semi-conducteur (6) sur la face de dessous de la bande support (1);
- raccordement électrique de la surface de contact (C1-C9) avec le circuit à semi-conducteur (6); et
- exécution d'un procédé de moulage par injection de façon à ce que, sur la face de dessous autour du circuit à semi-conducteur (6), une masse de scellement (8) est réalisée, cette masse de scellement (8) présentant les dimensions extérieures conformes à une spécification standard d'un support de données portable.

3. Procédé selon une des revendications précédentes, la conduite d'amenée (3) et/ou les surfaces de contact (C1-C9) étant sectionnées ou abrasées dans la zone marginale au moyen d'un outil de coupe (9).

4. Procédé selon une des revendications précédentes, la conduite d'amenée (3) et/ou les surfaces de contact (C1-C9) étant passivées et/ou vernies dans la zone marginale.

5. Procédé selon une des revendications précédentes, la conduite d'amenée évoluant à l'intérieur du champ de contact (2) pour les surfaces de contact (C1-C9) distinctes.

6. Procédé selon une des revendications précédentes, le champ de contact (2) étant réalisé en plusieurs couches, et après la réalisation d'une première couche, en particulier d'une couche de cuivre, la conduite d'amenée (3) et les zones à enlever des surfaces de contact (C1-C9) étant masquées, de telle sorte que, au-dessus des zones masquées, aucune autre couche, en particulier aucune couche de nickel ou d'or, ne sont réalisées.

7. Procédé selon une des revendications précédentes, le support de données étant, avant une étape d'isolation, personnalisé électriquement et/ou optiquement dans une unité de personnalisation, ce par quoi une individualisation du support de données a lieu.

8. Procédé selon une des revendications précédentes, le support de données étant isolé, ce qui a lieu en ce que la partie de la bande support jointe à la masse de scellement est séparée du reste de la bande support.
